# EUROPEAN PATENT APPLICATION

(11) **EP 4 502 727 A1**
(43) Date of publication of application: **05.02.2025**
(21) Application number: 23780705.2
(22) Date of filing: 29.03.2023
(51) Int. Cl.: G03F 1/24, G03F 1/32, G03F 1/58

(54) **REFLECTIVE PHOTOMASK BLANK AND REFLECTIVE PHOTOMASK**

(30) Priority: 29.03.2022 JP 2022054284
(71) Applicant: Tekscend Photomask Corp., Tokyo 105-7133 (JP)
(72) Inventor: YAMAGATA, Yuto, Tokyo 108-0023 (JP); MIYAWAKI, Daisuke, Tokyo 108-0023 (JP); SEKI, Kazunori, Tokyo 108-0023 (JP); NAKANO, Hideaki, Tokyo 108-0023 (JP)
(74) Representative: Hoffmann Eitle
(86) International application number: PCT/JP2023/012835
(87) International publication number: WO 2023/190696

(57) **Abstract**

An object of the present disclosure is to provide a reflective photomask blank and a reflective photomask having high transferability by making the most use of a phase shift effect. The reflective photomask blank (10) according to an aspect of the present disclosure includes a substrate (1), a reflective layer (2) having a multi-layer film structure, formed on the substrate (1), and configured to reflect an EUV light, a protective layer (3) formed on the reflective layer (2) and configured to protect the reflective layer (2), and an absorption layer (4) formed on the protective layer (3) and configured to absorb the EUV light, in which the absorption layer (4) includes an absorption layer (4a) and an absorption layer (4b) having different functions from each other, and the absorption layer (4) has a phase difference in a range of 190 degrees or more and 270 degrees or less.

## Description

### Technical Field

The present disclosure relates to a reflective photomask blank and a reflective photomask.

### Background Art

In a manufacturing process of semiconductor devices, a demand for miniaturization by a photolithography technology has increased with the miniaturization of the semiconductor devices. The minimum development dimension of a transfer pattern in the photolithography largely depends on the wavelength of an exposure light source, and the minimum resolution dimension can be made smaller as the wavelength is shorter. Therefore, as the exposure light source in a manufacturing process of advanced semiconductor devices, an EUV (Extreme Ultraviolet) having a wavelength of 13.5 nm has been replaced with ArF excimer laser light of the related art having a wavelength of 193 nm.

Most materials have high light absorptivity to the EUV, and therefore a dioptric system utilizing light transmission of the related art cannot be used. Thus, an optical member of an exposure machine is not a lens but a mirror. A photomask is also a reflective EUV photomask in place of a transmission-type photomask of the related art. Incident light and reflected light on the EUV photomask cannot be coaxially designed. Thus, in an EUV lithography, a technique is commonly employed which includes making the EUV light incident by tilting the optical axis by 6° from a vertical direction of the EUV photomask and emitting reflected light reflected at an angle of -6° to a semiconductor substrate. However, since the optical axis is inclined, a problem called a shadowing effect may occur in which the transfer performance is deteriorated by a shadow of a pattern (absorption pattern layer) of the EUV photomask is formed by the EUV light incident on the EUV photomask. Therefore, there is a demand for reducing the shadowing effect and improving the transfer performance.

In a current EUV photomask, a film containing tantalum (Ta) as a main component having a film thickness of 60 to 90 nm is used as a light absorption layer. In a case where the exposure for a pattern transfer is performed using this EUV photomask, line width errors and pattern misregistration may occur on the wafer depending on the line width, the orientation, the pitch, and the like of the absorption pattern, which may deteriorate the transfer quality. The influence of the shadowing effect is more remarkable as a pattern line width is finer.

In response to this problem, a reflective photomask in which an absorption layer pattern (absorption pattern layer) having a thin film thickness is formed by using a material having a high extinction coefficient k in the absorption layer has been proposed in order to reduce the shadowing effect [for example, see PTL 1].

In addition, with further miniaturization, in recent years, the adoption of a reflective mask blank using a phase shift effect has also been considered. The phase shift effect refers to an effect of improving a transfer contrast and improving a resolution of a transfer pattern by adjusting a phase of transmitted light that has passed through a phase shift portion adjacent to an opening portion such that the phase of the transmitted light is reversed with respect to a phase of transmitted light that has passed through the opening portion, thereby weakening a light intensity of the portion at which the transmitted light interferes with each other. Therefore, by using the phase shift effect also in the reflective mask blank, it is expected that the transferability can be further improved.

For example, in a reflective mask using the phase shift effect disclosed in PTL 2, an optimal value of the phase difference is set to 170 to 190 degrees. This is a value including 180 degrees, which is an optimal value of a phase difference of a transmission type phase shift mask of the related art.

However, in a case of the reflective mask, an EUV light is tilted and incident, and thus a portion of the reflected light passes through an edge portion of an absorption layer pattern. Since the reflected light that hits the edge portion has a phase deviated from the reflected light on a central portion of the pattern, the optimal phase difference of the absorption layer is different from 180 degrees.

In addition, the reflective mask blank using the phase shift effect described in PTL 3 limits a combination of a film thickness and a material composition of a phase shift layer from the reflectivity and the phase difference for improving the contrast. As a result, with the technology described in PTL 3, the phase shift layer is formed into a thin film having a film thickness of 60 nm or less, and the phase shift effect is obtained while reducing the shadowing effect.

However, in PTL 3, a film thickness of the phase shift layer is derived from a material, a desired reflectivity, and a desired phase, and it is claimed that the film thickness is thinner than the film thickness in the related art, but actual transferability is not described. In a case where the phase shift layer is configured with a material having a large absorption of an EUV light, such as Ni or Co, for example, even in a case where the film thickness is thinner than the film thickness in the related art, the strong interference of the obliquely incident EUV light may hinder the improvement in transferability.

As described above, in the reflective phase shift mask according to the related art, the phase shift effect cannot be sufficient utilized (used), and transferability (particularly resolution) thereof was not sufficient.

### Citation List

### Patent Literatures

PTL 1: WO 2018/159785
PTL 2: JP 6287099 B
PTL 3: WO 2019/225737

### Summary of Invention

### Technical problem

The present disclosure is to provide a reflective photomask blank and a reflective type photomask maximizing a phase shift effect and having high transferability (particularly resolution), by forming an absorption film (absorption layer) in which an absorption control film that absorbs an EUV light and a phase control film that controls a phase are combined.

More specifically, the present invention is to provide a reflective photomask enabling thin film formation of an absorption film (absorption layer) by providing an absorption control film having a large extinction coefficient k and a phase control film having a small refractive index in an absorption layer, enabling to have a desired phase difference and improve transferability by changing a combination of each layer (each film) of the absorption control film and the phase control film or a film thickness of each of the layers, and a reflective photomask blank for manufacturing the reflective photomask.

### Solution to Problem

The present invention is made to solve the problems described above, and according to an aspect of the present invention, there is provided a reflective photomask blank including: a substrate; a reflective layer having a multi-layer film structure, formed on the substrate, and configured to reflect an EUV light; a protective layer formed on the reflective layer and configured to protect the reflective layer; and an absorption layer formed on the protective layer and configured to absorb the EUV light, in which the absorption layer has a multi-layer structure of two or more layers having different functions, and the absorption layer has a phase difference in a range of 190 degrees or more and 270 degrees or less.

In addition, in the reflective photomask blank according to the aspect of the present invention, the absorption layer may include at least an absorption control film.

In addition, in the reflective photomask blank according to the aspect of the present invention, the absorption layer may include the absorption control film and a phase control film.

In addition, in the reflective photomask blank according to the aspect of the present invention, the absorption control film may contain a material having an extinction coefficient k of 0.041 or more, and a film thickness of the absorption layer may be 60 nm or less.

In addition, in the reflective photomask blank according to the aspect of the present invention, the absorption control film may be configured with a material containing at least one or more elements of tin (Sn), indium (In), tantalum (Ta), silver (Ag), tellurium (Te), nickel (Ni), cobalt (Co), copper (Cu), platinum (Pt), palladium (Pd), iridium (Ir), gold (Au), or zinc (Zn).

In addition, in the reflective photomask blank according to the aspect of the present invention, the absorption layer may include the absorption control film and a phase control film, and the phase control film may have a refractive index n with respect to the EUV light less than 0.93.

In addition, in the reflective photomask blank according to the aspect of the present invention, the absorption layer may include the absorption control film and a phase control film, and the phase control film may have a refractive index n with respect to the EUV light less than 0.92.

In addition, in the reflective photomask blank according to the aspect of the present invention, the absorption layer may include the absorption control film and a phase control film, and the phase control film may be configured with a material containing at least one or more elements of ruthenium (Ru), rhodium (Rh), molybdenum (Mo), palladium (Pd), silver (Ag), platinum (Pt), gold (Au), osmium (Os), iridium (Ir), or rhenium (Re).

In addition, in the reflective photomask blank according to the aspect of the present invention, the absorption layer may have a phase difference in a range of 210 degrees or more and 265 degrees or less.

In addition, in the reflective photomask blank according to the aspect of the present invention, the absorption layer may have a phase difference in a range of 230 degrees or more and 260 degrees or less.

In addition, according to an aspect of the present invention, there is provided a reflective photomask including a substrate; a reflective layer having a multi-layer film structure, formed on the substrate, and configured to reflect an EUV light; a protective layer formed on the reflective layer and configured to protect the reflective layer; and an absorption pattern layer formed on the protective layer and configured to absorb the EUV light, in which the absorption pattern layer has a multi-layer structure of two or more layers having different functions, and the absorption pattern layer has a phase difference in a range of 190 degrees or more and 270 degrees or less.

In addition, in the reflective photomask according to the aspect of the present invention, the absorption pattern layer may include at least a patterned absorption control film.

In addition, in the reflective photomask according to the aspect of the present invention, the absorption pattern layer may include the absorption control film and a patterned phase control film.

In addition, in the reflective photomask according to the aspect of the present invention, the absorption control film may contain a material having an extinction coefficient k of 0.041 or more, and a film thickness of the absorption pattern layer may be 60 nm or less.

In addition, in the reflective photomask according to the aspect of the present invention, the absorption control film may be configured with a material containing at least one or more elements of tin (Sn), indium (In), tantalum (Ta), silver (Ag), tellurium (Te), nickel (Ni), cobalt (Co), copper (Cu), platinum (Pt), palladium (Pd), iridium (Ir), gold (Au), or zinc (Zn).

In addition, in the reflective photomask according to the aspect of the present invention, the absorption pattern layer may include the absorption control film and a patterned phase control film, and the phase control film may have a refractive index n with respect to the EUV light less than 0.93.

In addition, in the reflective photomask according to the aspect of the present invention, the absorption pattern layer may include the absorption control film and a patterned phase control film, and the phase control film may have a refractive index n with respect to the EUV light less than 0.92.

In addition, in the reflective photomask according to the aspect of the present invention, the absorption pattern layer may include the absorption control film and a patterned phase control film, and the phase control film may be configured with a material containing at least one or more elements of ruthenium (Ru), rhodium (Rh), molybdenum (Mo), palladium (Pd), silver (Ag), platinum (Pt), gold (Au), osmium (Os), iridium (Ir), or rhenium (Re).

In addition, in the reflective photomask according to the aspect of the present invention, the absorption pattern layer may have a phase difference in a range of 210 degrees or more and 265 degrees or less.

In addition, in the reflective photomask according to the aspect of the present invention, the absorption pattern layer may have a phase difference in a range of 230 degrees or more and 260 degrees or less.

### Advantageous Effects of Invention

According to the reflective photomask blank and the reflective photomask according to an aspect of the present disclosure, a sufficient phase shift effect is obtained, and wafer transfer performance (particularly resolution) can be improved.

### Brief Description of Drawings

FIG. 1 is a cross-sectional view illustrating a structure of a reflective photomask blank according to the present embodiment;
FIG. 2 is a cross-sectional view illustrating a structure of a reflective photomask according to the present embodiment;
FIG. 3 is a graph illustrating a relationship between a phase difference of the reflective photomask according to an embodiment of the present invention and an NILS;
FIG. 4 is a graph illustrating an optical constant of each metal material at a wavelength of an EUV light;
FIG. 5 is a graph illustrating a relationship between a phase difference and a film thickness of the reflective photomask according to the embodiment of the present invention;
FIG. 6 is a schematic cross-sectional view illustrating a structure of the reflective photomask according to the embodiment of the present invention;
FIG. 7 is a schematic cross-sectional view illustrating a structure of a reflective photomask blank according to an example of the present invention;
FIG. 8 is a schematic cross-sectional view illustrating a manufacturing step of a reflective photomask according to an example of the present invention;
FIG. 9 is a schematic cross-sectional view illustrating a manufacturing step of a reflective photomask according to an example of the present invention;
FIG. 10 is a schematic cross-sectional view illustrating a manufacturing step of a reflective photomask according to an example of the present invention;
FIG. 11 is a schematic cross-sectional view illustrating a structure of a reflective photomask according to an example of the present invention;
FIG. 12 is a schematic cross-sectional view illustrating a structure of a reflective photomask blank according to a comparative example of the present invention; and
FIG. 13 is a schematic cross-sectional view illustrating a structure of a reflective photomask according to a comparative example of the present invention.

### Description of Embodiments

An embodiment of the present disclosure will be described with reference to the drawings.

Here, the configuration illustrated in the drawings is a schematic configuration, and a relationship between a thickness and a plane dimension, a proportion of a thickness of each layer, and the like are different from actual ones. In addition, embodiments shown below are examples of a configuration for implementing technical idea of the present disclosure and the technical idea of the present disclosure does not intend to limit materials, shapes, structures, and the like of constituent components to the following embodiments. The technical idea of the present disclosure may be modified in various manners within the technical scope specified by the claims described in the claims.

### (Configuration of reflective photomask blank and reflective photomask)

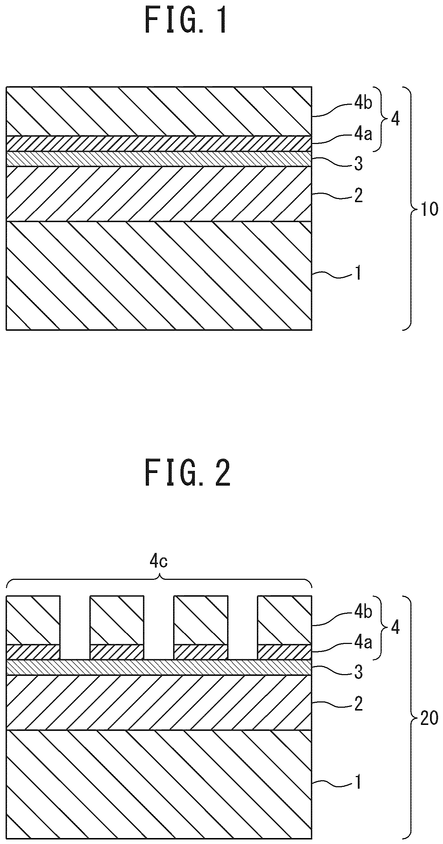

FIG. 1 is a schematic cross-sectional view illustrating a reflective photomask blank 10 according to an embodiment of the present invention. As illustrated in FIG. 1, a reflective photomask blank 10 according to the embodiment of the present invention includes a substrate 1, a reflective layer 2 formed on the substrate 1, a protective layer 3 formed on the reflective layer 2, and an absorption layer 4 formed on the protective layer 3, in which the absorption layer 4 is configured with two or more layers having different functions from each other. FIG. 1 illustrates an example of an absorption layer 4 configured with two layers having different functions from each other, and one layer thereof is referred to as an absorption layer 4a and another layer formed on the absorption layer 4a is referred to as an absorption layer 4b.

The absorption layers 4a and 4b may be either the absorption control film or the phase control film, and either may be the upper layer or the lower layer. That is, in the present embodiment, the absorption layer 4a may be used as the absorption control film, and the absorption layer 4b may be used as the phase control film, or the absorption layer 4a may be used as the phase control film, and the absorption layer 4b may be used as the absorption control film.

In addition, among the components constituting at least one of the absorption control film or the phase control film, at least one component may have an inclined structure that gradually changes from a surface layer side toward the substrate 1 side, that is, may have a concentration gradient.

In addition, FIG. 2 is a schematic cross-sectional view illustrating a reflective photomask 20 according to the embodiment of the present invention. Here, the reflective photomask 20 according to the embodiment of the present invention illustrated in FIG. 2 is formed by patterning the absorption layer 4 of the reflective photomask blank 10 according to the embodiment of the present invention illustrated in FIG. 1. Hereinafter, each layer will be described in detail.

### (Substrate)

As the substrate 1 according to the embodiment of the present invention, for example, a flat Si substrate, a synthetic quartz substrate, or the like can be used. In addition, as the substrate 1, a low thermal expansion glass to which titanium is added can be used, however, the present invention is not limited thereto, as long as it is a material having a small thermal expansion coefficient.

In addition, a back surface conductive film can be formed on a surface of the substrate 1 on which the reflective layer 2 is not formed, although not illustrated. The back surface conductive film is a film for fixing the reflective photomask 20 using a principle of an electrostatic chuck when the reflective photomask 20 is installed in an exposure machine.

### (Reflective layer)

The reflective layer 2 according to the embodiment of the present invention may be any one as long as it reflects an EUV light (extreme ultraviolet light) which is an exposure light, and is a multi-layer reflective film (that is, an EUV light reflective film having a multi-layer film structure) obtained by a combination of materials having greatly different refractive indices with respect to the EUV light. The reflective layer 2 including the multi-layer reflective film may be formed by, for example, repeatedly depositing a layer of a combination of Mo (molybdenum) and Si (silicon) or Mo (molybdenum) and Be (beryllium) for about 40 cycles.

### (Protective layer)

The protective layer 3 according to the embodiment of the present invention is a layer which functions as an etching stopper for preventing damage to the reflective layer 2 when an absorption pattern 4c is formed by etching. The protective layer 3 may not be formed depending on the material of the reflective layer 2 or etching conditions. The protective layer 3 is formed of a material having resistance to dry etching performed when forming a pattern of the absorption layer 4. For example, a material of the protective layer 3 may be ruthenium (Ru).

### (Absorption layer)

As illustrated in FIG. 1, the absorption layer 4 is a layer formed on the protective layer 3 and is a layer which absorbs the EUV light which is the exposure light. In addition, the absorption layer 4 is a layer which forms an absorption pattern 4c which is a fine pattern to be transferred. That is, by removing a part of the absorption layer 4 of the reflective photomask blank 10, that is, by patterning the absorption layer 4, an absorption pattern (the absorption pattern layer) 4c of the reflective photomask 20 illustrated in FIG. 2 is formed.

In the absorption pattern 4c, when the EUV light is incident and reflected through a pattern opening portion without passing through the absorption layer 4, the reflected light is affected by the protective layer 3 and the reflective layer 2, and the phase of an original incident light is changed. Meanwhile, when the EUV light is incident and/or reflected through the absorption layer 4, the reflected light is affected by the protective layer 3 and the reflective layer 2, and is also affected by the absorption layer 4, and the phase of the original incident light is changed. That is, the reflected light of the EUV light generated through the absorption layer 4 causes a desired phase difference based on film characteristics of the absorption layer 4 between the reflected light generated through the pattern opening portion.

Generally, the phase difference between the absorption layer 4 and the opening portion generated as a result of patterning is determined uniquely and can be obtained by calculation by optical theory, as long as an optical constant (a refractive index n, extinction coefficient k) and a film thickness of each layer of the reflective photomask blank and the reflective photomask, and a wavelength of light used are determined (for more details, for example, see Applied Physics Technology Selection 3, Sadafumi Yoshida, "Thin Films", Baifukan, 1990). In other words, the "phase difference" in the present embodiment refers to a difference between a phase of reflected light of the absorption layer 4 and a phase of reflected light (at the opening portion) of the reflective layer 2.

In the present embodiment, as each value of the refractive index n and the extinction coefficient k used in the calculation of the above-described phase difference, the actual measured value using the EUV light was used.

The normalized image log-slope (NILS) is a value of contrast obtained by NILS = w x dln(I)/dx ... Equation (1), and becomes an index of a resolution of a wafer pattern when the wafer pattern is formed using the reflective photomask 20.

Here, "w" represents a line width and "I" represents an intensity of an energy latent image. The larger the value of NILS, the higher the resolution of the transfer pattern.

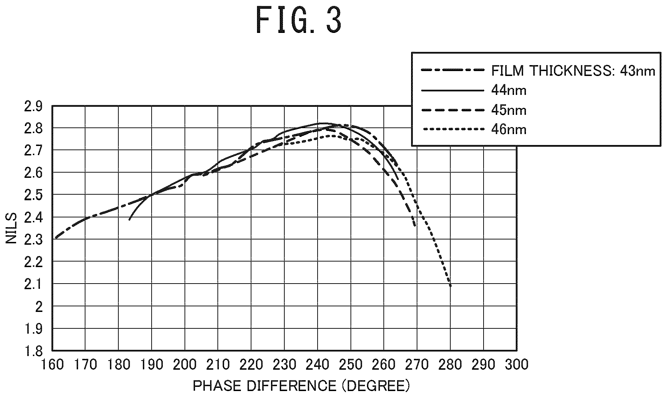

FIG. 3 illustrates a relationship between the normalized image log-slope (NILS) of the wafer pattern in a case of being transferred to the wafer using the reflective photomask 20, the phase difference of the reflective photomask 20, and the film thickness of the absorption control film constituting the reflective photomask 20.

FIG. 3 is a diagram illustrating a relationship of a two-layered absorption film (absorption layer) in which an absorption control film (hereinafter, also referred to as "absorption control film made of SnO" for convenience) made of tin (Sn) and oxygen (O) with an extinction coefficient k of 0.070 is formed as an absorption layer 4a and a phase control film made of ruthenium (Ru) with a refractive index n of 0.89 is formed as an absorption layer 4b on the absorption control film, in which, from the result of the phase difference and the NILS when a hole pattern of 19 nm on a wafer is exposed under an exposure condition of an Numerical Aperture NA of 0.33, the relationship is illustrated at four levels of film thicknesses of the absorption film (absorption layer) of 43 nm, 44 nm, 45 nm, and 46 nm. The film thicknesses of SnO and Ru were respectively changed to 0 to 26 nm and 0 to 47 nm to intentionally create different conditions of the phase difference.

From FIG. 3, it can be seen that the NILS value is maximized in a range in which the phase difference is in the vicinity of 230 degrees to 260 degrees.

In addition, from FIG. 3, it can be seen that, in a case where the phase difference is 180 degrees at a film thickness of 43 nm, the value of NILS is 2.46.

Here, in a case where the phase difference is 190 degrees, the NILS is 2.50 at a film thickness of 44 nm, and the NILS is 1% or more larger than a case where the phase difference is 180 degrees at a film thickness of 43 nm.

In addition, in a case where the phase difference is 270 degrees, the NILS is 2.50 at a film thickness of 46 nm, and the NILS is 1% or more larger than a case where the phase difference is 180 degrees at a film thickness of 43 nm.

In addition, in a case where the phase difference is 210 degrees, the NILS is 2.64 at a film thickness of 44 nm, and the NILS is 7% or more larger than a case where the phase difference is 180 degrees at a film thickness of 43 nm.

In addition, in a case where the phase difference is 265 degrees, the NILS is 2.64 at a film thickness of 43 nm, and the NILS is 7% or more larger than a case where the phase difference is 180 degrees at a film thickness of 43 nm.

In addition, in a case where the phase difference is 230 degrees, the NILS is 2.74 at a film thickness of 43 nm, and the NILS is 11% or more larger than a case where the phase difference is 180 degrees at a film thickness of 43 nm.

In addition, in a case where the phase difference is 260 degrees, the NILS is 2.74 at a film thickness of 46 nm, which is 11% or more larger than a case where the phase difference is 180 degrees at a film thickness of 43 nm.

As described above, compared to a case where the phase difference is 180 degrees, the NILS is improved by 1% or more when the phase difference is in a range of 190 degrees or more and 270 degrees or less, by 7% or more when the phase difference is in a range of 210 degrees or more and 265 degrees or less, or by 11% or more when the phase difference is in a range of 230 degrees or more and 260 degrees or less.

From the above, in order to improve the resolution, the phase difference of the absorption layer 4 is preferably in a range of 190 degrees or more and 270 degrees or less, more preferably in a range of 210 degrees or more and 265 degrees or less, and most preferably in a range of 230 degrees or more and 260 degrees or less.

As described above, the present inventors have found that the optimum phase difference of the absorption layer in the reflective photomask is a value different from the "180 degrees" used in a design concept in the related art.

In the EUV lithography, the EUV light is incident obliquely and is reflected by the reflective layer 2, but the absorption layer 4 in which the absorption pattern 4c is formed may deteriorate the transfer performance onto the wafer (semiconductor substrate) due to the shadowing effect of a light path. The deterioration in the transfer performance can be reduced by reducing the thickness of the absorption layer 4 that absorbs EUV light.

A film thickness of the absorption layer 4 is preferably 60 nm or less. In a case where the film thickness of the absorption layer 4 is 60 nm or less, the film thickness is thinner than a film thickness of the Ta-based absorption film (absorption layer) in the related art, so that the shadowing effect can be reduced and the transfer performance can be improved.

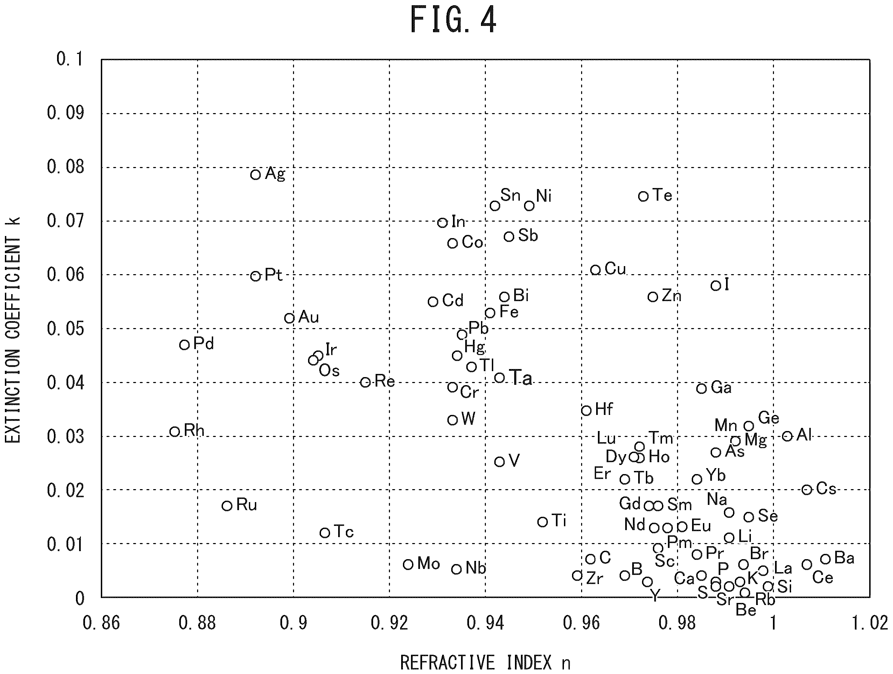

Here, FIG. 4 is a graph illustrating optical constants of a part of the metal materials with respect to the wavelength of the EUV light of 13.5 nm. A horizontal axis of FIG. 4 represents a refractive index n, and a vertical axis represents an extinction coefficient k. A film thickness of tantalum (Ta), which is a main material of the absorption layer in the related art, is 60 to 90 nm. Therefore, when the film thickness of the absorption layer 4 can be set to 60 nm or less, the transfer performance can be improved as compared with the absorption layer (reflective photomask) in the related art. A film thickness of the absorption layer 4 according to the present embodiment is preferably 50 nm or less, and more preferably 40 nm or less. In the absorption layer 4 according to the present embodiment, the lower limit value thereof is not particularly limited, but is preferably 20 nm or more, and more preferably 25 nm or more.

In order to thin the absorption control film, it is necessary to use, as a material constituting the absorption control film, a material (high extinction coefficient material) having a higher extinction coefficient k than the extinction coefficient k (0.041) of the Ta film of the related art. In addition, in order to further enable thinning of the absorption control film, the extinction coefficient k of the material constituting the absorption control film is preferably 0.05 or more, and more preferably 0.06 or more.

By using a material having an extinction coefficient k of 0.041 or more as the material constituting the absorption control film, the absorption control film is sufficiently thinned to reduce the shadowing effect. Specific examples of the material having the extinction coefficient k of 0.06 or more include tin (Sn), indium (In), silver (Ag), tellurium (Te), nickel (Ni), cobalt (Co), copper (Cu), and platinum (Pt), specific examples of the material having the extinction coefficient k of 0.05 or more include gold (Au) and zinc (Zn), and specific examples of the material having the extinction coefficient k of 0.041 or more include tantalum (Ta), palladium (Pd), and iridium (Ir). It is desirable that the material constituting the absorption control film is a material containing at least one of these materials (elements). In particular, when the material constituting the absorption control film is an oxide, a nitride, or an oxynitride of Sn, In, or Ta, since these materials have a high melting point, the further improvement of the heat resistance of the absorption control film and the processability of the absorption control film in an etching apparatus of the related art.

Among the entire materials constituting the absorption control film, the high extinction coefficient material is preferably contained in 50% by mass or more, more preferably contained in 70% by mass or more, and still more preferably contained in 90% by mass or more. When the content of the high extinction coefficient material is within the above-described numerical range, the high extinction coefficient material reliably functions as the absorption control film.

In the present embodiment, the film thickness of the absorption control film is preferably in a range of 1 nm or more and 30 nm or less, more preferably in a range of 3 nm or more and 20 nm or less, and still more preferably in a range of 3 nm or more and 15 nm or less. When the film thickness of the absorption control film is within the above-described numerical range, an absorption rate of the EUV light can be easily controlled (adjusted).

In addition, in the present embodiment, the film thickness of the absorption control film with respect to the film thickness of the entire absorption layer 4 is preferably in a range of 2.5% or more and less than 50%, more preferably in a range of 10% or more and 40% or less, and still more preferably in a range of 10% or more and 30% or less. When the film thickness of the absorption control film with respect to the film thickness of the entire absorption layer 4 is within the above-described numerical range, the absorption rate of the EUV light can be easily controlled (adjusted).

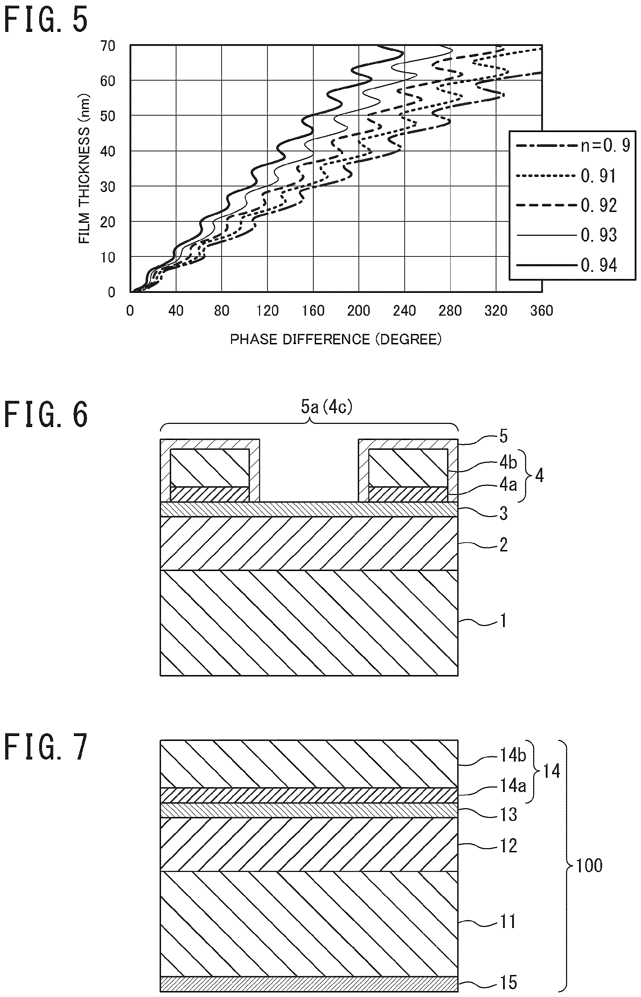

FIG. 5 is a graph illustrating a relationship between a film thickness of the absorption layer 4 and a phase difference when the absorption control film having the extinction coefficient k of 0.07 and the refractive index n of 0.93 was formed to a film thickness of less than 1 nm and the phase control films having the extinction coefficient k of 0.03 and the refractive indices n of 0.90, 0.91, 0.92, 0.93, and 0.94 with respect to the EUV light were formed thereon, the relationship being calculated by simulation. The "film thickness of the absorption layer 4" essentially means the thickness of the phase control film itself in practice because the film thickness of the absorption control film is negligibly thin compared to the thickness of the phase control film.

As illustrated in FIG. 5, as the refractive index n of the phase control film constituting the absorption layer 4 is smaller, the film thickness for obtaining the desired phase difference can be made thinner.

As described above, in order to reduce the shadowing effect, in addition to the thinning of the absorption control film by increasing the extinction coefficient k of the material constituting the absorption control film, thinning of the phase control film by reducing the refractive index n of the material constituting the phase control film is also effective.

As illustrated in FIG. 5, in a case where the refractive index n of the phase control film constituting the absorption layer 4 is 0.93, the minimum film thickness of the absorption layer 4 (phase control film) for obtaining the phase difference in a range of 230 degrees or more and 260 degrees or less is 60 nm, which is the same as the film thickness of the Ta-based absorption film (absorption layer) in the related art. Therefore, when the refractive index n of the phase control film constituting the absorption layer 4 is less than 0.93, it is preferable to set the film thickness of the absorption layer 4 (phase control film) to be less than 60 nm. In addition, when the refractive index n of the phase control film constituting the absorption layer 4 is less than 0.92, the lowest film thickness of the absorption layer 4 (phase control film) for obtaining the phase difference in a range of 230 degrees or more and 260 degrees or less is 50 nm or less, which is more preferable.

In the present embodiment, the film thickness of the phase control film is preferably in a range of 10 nm or more and 50 nm or less, more preferably in a range of 15 nm or more and 40 nm or less, and still more preferably in a range of 20 nm or more and 30 nm or less. When the film thickness of the phase control film is within the above-described numerical range, the phase difference can be easily controlled (adjusted).

In addition, in the present embodiment, the film thickness of the phase control film with respect to the film thickness of the entire absorption layer 4 is preferably in a range of 50% or more and less than 95%, more preferably in a range of 60% or more and 85% or less, and still more preferably in a range of 70% or more and 80% or less. When the film thickness of the phase control film with respect to the film thickness of the entire absorption layer 4 is within the above-described numerical range, the phase difference can be easily controlled (adjusted).

The film thickness of the entire absorption layer 4 configured with the phase control film and the absorption control film is preferably 60 nm or less, more preferably 50 nm or less, and still more preferably 40 nm or less, as described above.

In addition, in the absorption layer 4 configured with the phase control film and the absorption control film, the film thickness of the phase control film is preferably thicker than the film thickness of the absorption control film. For example, the film thickness of the phase control film is preferably 3 times or more, more preferably 5 times or more, and still more preferably 8 times or more the film thickness of the absorption control film.

By using a material having a refractive index n of less than 0.93 (low refractive index material) as a material constituting the phase control film, the phase control film is sufficiently thinned, and the shadowing effect can be reduced. Specifically, examples of the material having a refractive index n of less than 0.93 include ruthenium (Ru), rhodium (Rh), molybdenum (Mo), palladium (Pd), silver (Ag), platinum (Pt), gold (Au), osmium (Os), iridium (Ir), and rhenium (Re). It is desirable that the material constituting the phase control film is a material containing at least one of these materials (elements).

The material constituting the absorption layer 4 can be a material (amorphous material) that is sufficiently amorphous (that is, a material having an amorphous property) and that contains, in addition to the above-described materials (that is, the high extinction coefficient material in which the extinction coefficient k is more than 0.041 or the low refractive index material in which the refractive index n is less than 0.93), for example, beryllium (Be), calcium (Ca), scandium (Sc), vanadium (V), manganese (Mn), iron (Fe), copper (Cu), germanium (Ge), arsenic (As), strontium (Sr), technetium (Tc), rhodium (Rh), barium (Ba), tungsten (W), rhenium (Re), osmium (Os), gold (Au), and the like, so that a roughness, an in-plane dimensional uniformity, and an in-plane uniformity of a transfer image can be improved.

In addition, by containing, for example, chromium (Cr), titanium (Ti), aluminum (Al), silicon (Si), zirconium (Zr), vanadium (V), hafnium (Hf), niobium (Nb), yttrium (Y), lead (Pb), gallium (Ga), or the like in the material constituting the absorption layer 4, in addition to the above-described high extinction coefficient material or low refractive index material, the material can be a material which is less likely to react with hydrogen radicals and has higher hydrogen radical resistance.

In addition, as illustrated in FIG. 6, by containing, for example, tantalum (Ta), niobium (Nb), chromium (Cr), titanium (Ti), aluminum (Al), vanadium (V), hafnium (Hf), or the like in the material constituting the absorption layer 4, in addition to the high extinction coefficient material or the low refractive index material described above, an oxide film 5 having hydrogen radical resistance can be formed such that the exposed surface of the absorption layer 4 is covered. A film thickness of the oxide film 5 is preferably in a range of 1 nm or more and 5 nm or less, more preferably in a range of 2 nm or more and 4 nm or less, and still more preferably in a range of 2.5 nm or more and 3.5 nm or less. When the film thickness of the oxide film 5 is within the above-described numerical range, excellent hydrogen radical resistance is imparted.

When a material having a refractive index n close to 1 and an extinction coefficient k close to 0, for example, SiO₂ is used as the oxide film 5, the film thickness of the oxide film 5 may be 10 nm or more when the NILS is higher than the Ta-based absorption film in the related art. When the film thickness is 10 nm or more, a coating film can withstand erosion by a chemical liquid during the cleaning of the mask more than in a case where the film thickness is thin, and the mask can be used for a long time.

In addition, in the film thickness of the oxide film 5, a film thickness of the oxide film 5 formed on an upper surface of the absorption layer 4 may be thicker than a film thickness of the oxide film 5 formed on a side surface of the absorption layer 4. Since a collision frequency of hydrogen radicals is higher on the upper surface of the absorption layer 4 than on the side surface of the absorption layer 4, when the film thickness of the oxide film 5 formed on the upper surface of the absorption layer 4 is thicker than the film thickness of the oxide film 5 formed on the side surface of the absorption layer 4, durability of the absorption layer 4 is improved.

In addition, in the film thickness of the oxide film 5, the film thickness of the oxide film 5 formed on the upper surface of the absorption layer 4 may be thinner than the film thickness of the oxide film 5 formed on the side surface of the absorption layer 4. Since the damage to the absorption layer 4 by the hydrogen radical is more likely to affect the transfer performance (particularly resolution) from the side surface of the absorption layer 4 than from the upper surface of the absorption layer 4, when the film thickness of the oxide film 5 formed on the side surface of the absorption layer 4 is thicker than the film thickness of the oxide film 5 formed on the upper surface of the absorption layer 4, the transfer performance (particularly resolution) of the absorption layer 4 is improved.

In addition, by containing, for example, rhodium (Rh), niobium (Nb), platinum (Pt), titanium (Ti), palladium (Pd), or the like in the material constituting the absorption layer 4, in addition to the above-described high extinction coefficient material or low refractive index material, the material can be a material having low reactivity with a chemical liquid such as SPM or APM, which is generally used for cleaning a mask, and having higher cleaning resistance.

In addition, by containing, for example, silicon nitride (SiN), tantalum oxide (TaO), or the like, in the material constituting the absorption layer 4, in addition to the above-described high extinction coefficient material or low refractive index material, the material can be a material having high light absorption at a wavelength of 190 nm to 260 nm and having contrast enhancement of inspection light.

In addition, by containing, for example, cobalt (Co), ruthenium (Ru), iridium (Ir), gold (Au), palladium (Pd), platinum (Pt), molybdenum (Mo), or the like, in the material constituting the absorption layer 4, in addition to the above-described high extinction coefficient material or low refractive index material, the material can be a material in which a refractive index n is less than 0.95 with respect to a wavelength of 13.5 nm and a phase shift property is improved.

The example of the effect of the material which can be contained in the absorption layer 4 has been described above, but the effect of each material is not limited to the above-described example and a plurality of effects may be exhibited.

Among the materials constituting the phase control film, the above-described low refractive index material is preferably contained in 50% by mass or more, more preferably contained in 70% by mass or more, and still more preferably contained in 90% by mass or more. When the content of the low refractive index material is within the above-described numerical range, the low refractive index material reliably functions as a phase control film.

### [Examples]

Hereinafter, the present disclosure will be described in more detail with reference to examples, however, the present disclosure is not limited to examples.

### <Example 1>

As illustrated in FIG. 7, a synthetic quartz substrate having low thermal expansion was used as a substrate 11. 40 sheets of a multi-layer film of a pair of silicon (Si) and molybdenum (Mo), as a multi-layer reflective film 12, were deposited and formed on the substrate 11. A film thickness of the multi-layer reflective film (reflective layer) 12 was set to 280 nm.

Next, a capping layer (protective layer) 13 was formed on the multi-layer reflective film 12 such that a film thickness is 3.5 nm using ruthenium (Ru). Accordingly, a reflective portion including the multi-layer reflective film 12 and the capping layer 13 was formed on the substrate 11.

An absorption control film (lower layer 14a) made of tin (Sn) and oxygen (O) and having an extinction coefficient k of 0.070 was formed on the capping layer 13 such that a film thickness is 9 nm, and a phase control film (upper layer 14b) made of ruthenium (Ru) and having a refractive index n of 0.89 was formed on the absorption control film (lower layer 14a) such that a film thickness is 26 nm. When the crystallinity of the absorption layer 14 including the film made of tin (Sn) and oxygen (O) and the ruthenium (Ru) film, which were formed as described above, was measured by X-ray diffractometer (XRD), it was found to be amorphous. The above-described absorption control film consisting of tin (Sn) and oxygen (O) is denoted as "SnO" for convenience in the table. That is, in the present example, the composition of the absorption control film made of tin (Sn) and oxygen (O) is not limited to Sn:O = 1:1. The same applies to the following examples and comparative examples.

Next, a back surface conductive film 15 was formed on a side of the substrate 11 where no multi-layer reflective film 12 was formed such that a thickness is 100 nm using chromium nitride (CrN). The reflective photomask blank 100 was generated.

Each film was formed on the substrate 11 using a multi-source sputtering apparatus. A film thickness of each film was controlled by a sputtering time.

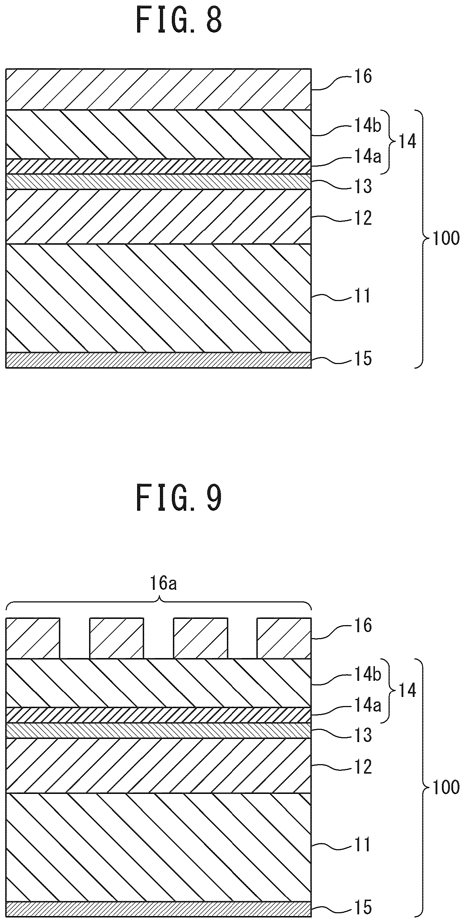

Next, a method for manufacturing the reflective photomask 200 will be described with reference to FIGS. 8 to 11. As illustrated in FIG. 8, a positive chemical amplification type resist (SEBP9012: manufactured by Shin-Etsu Chemical Co., Ltd.) was applied onto the absorption layer 14 of the reflective photomask blank 100 by spin coating to have a film thickness of 120 nm, and baked at 110°C for 10 minutes to form a resist film 16.

Next, a predetermined pattern was drawn on the resist film 16 with an electron beam drawing machine (JBX3030: manufactured by JEOL Ltd.).

Then, pre-bake processing was performed at 110°C for 10 minutes, and development processing was performed using a spray development machine (SFG3000: manufactured by Sigmameltec Co., Ltd.). Accordingly, a resist pattern 16a was formed as illustrated in FIG. 9.

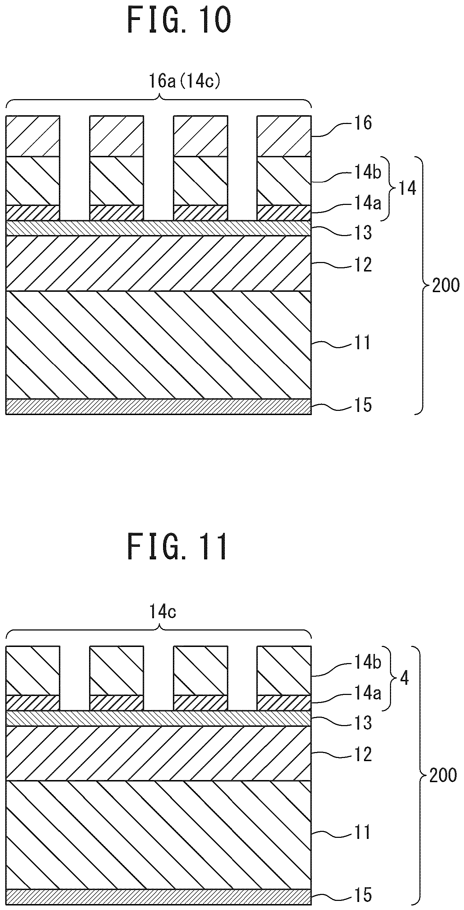

Next, using the resist pattern 16a as an etching mask, the phase control film (upper layer 14b) formed of Ru was subjected to dry etching using fluorine-based gas, and the absorption control film (lower layer 14a) formed of SnO was subjected to dry etching using chlorine-based gas, thereby patterning the absorption layer 14. As a result, as illustrated in FIG. 10, the absorption pattern 14c was formed on the absorption layer 14.

Next, the resist pattern 16a was peeled off to manufacture the reflective photomask 200 according to the present example, which is illustrated in FIG. 11.

In the present example, the absorption pattern 14c formed on the absorption layer 14 was a hole pattern with 76 nm on the reflective photomask 200 for transfer evaluation.

A phase difference of the absorption layer 14 of Example 1, which was formed as described above, at a wavelength of 13.5 nm was 192 degrees.

### <Example 2>

An absorption control film (lower layer 14a) made of tin (Sn) and oxygen (O) having an extinction coefficient k of 0.070 was formed such that a film thickness is 13 nm, and a phase control film (upper layer 14b) made of ruthenium (Ru) and having a refractive index n of 0.89 was formed such that a film thickness is 20 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 2 were manufactured by the same method as in Example 1, except for the absorption layer 14.

A phase difference of the absorption layer 14 of Example 2, which was formed as described above, at a wavelength of 13.5 nm was 192 degrees.

### <Example 3>

An absorption control film (lower layer 14a) made of tin (Sn) and oxygen (O) having an extinction coefficient k of 0.070 was formed such that a film thickness is 8 nm, and a phase control film (upper layer 14b) made of ruthenium (Ru) and having a refractive index n of 0.89 was formed such that a film thickness is 38 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 3 were manufactured by the same method as in Example 1, except for the absorption layer 14.

A phase difference of the absorption layer 14 of Example 3, which was formed as described above, at a wavelength of 13.5 nm was 266 degrees.

### <Example 4>

An absorption control film (lower layer 14a) made of tin (Sn) and oxygen (O) having an extinction coefficient k of 0.070 was formed such that a film thickness is 1.2 nm, and a phase control film (upper layer 14b) made of ruthenium (Ru) and having a refractive index n of 0.89 was formed such that a film thickness is 44 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 4 were manufactured by the same method as in Example 1, except for the absorption layer 14.

A phase difference of the absorption layer 14 of Example 4, which was formed as described above, at a wavelength of 13.5 nm was 266 degrees.

### <Example 5>

An absorption control film (lower layer 14a) made of tin (Sn) and oxygen (O) having an extinction coefficient k of 0.070 was formed such that a film thickness is 4 nm, and a phase control film (upper layer 14b) made of ruthenium (Ru) and having a refractive index n of 0.89 was formed such that a film thickness is 39 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 5 were manufactured by the same method as in Example 1, except for the absorption layer 14.

A phase difference of the absorption layer 14 of Example 5, which was formed as described above, at a wavelength of 13.5 nm was 248 degrees.

### <Example 6>

An absorption control film (lower layer 14a) made of tin (Sn) and oxygen (O) having an extinction coefficient k of 0.070 was formed such that a film thickness is 5 nm, and a phase control film (upper layer 14b) made of ruthenium (Ru) and having a refractive index n of 0.89 was formed such that a film thickness is 39 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 6 were manufactured by the same method as in Example 1, except for the absorption layer 14.

A phase difference of the absorption layer 14 of Example 6, which was formed as described above, at a wavelength of 13.5 nm was 248 degrees.

### <Example 7>

An absorption control film (lower layer 14a) made of tin (Sn) and oxygen (O) having an extinction coefficient k of 0.070 was formed such that a film thickness is 22 nm, and a phase control film (upper layer 14b) made of ruthenium (Ru) and having a refractive index n of 0.89 was formed such that a film thickness is 22 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 7 were manufactured by the same method as in Example 1, except for the absorption layer 14.

A phase difference of the absorption layer 14 of Example 7, which was formed as described above, at a wavelength of 13.5 nm was 210 degrees.

### <Example 8>

An absorption control film (lower layer 14a) made of tin (Sn) and oxygen (O) having an extinction coefficient k of 0.070 was formed such that a film thickness is 20 nm, and a phase control film (upper layer 14b) made of ruthenium (Ru) and having a refractive index n of 0.89 was formed such that a film thickness is 27 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 8 were manufactured by the same method as in Example 1, except for the absorption layer 14.

A phase difference of the absorption layer 14 of Example 8, which was formed as described above, at a wavelength of 13.5 nm was 263 degrees.

### <Example 9>

An absorption control film (lower layer 14a) made of tin (Sn) and oxygen (O) and having an extinction coefficient k of 0.070 was formed such that a film thickness is 21 nm, and a phase control film (upper layer 14b) including ruthenium (Ru) and having a refractive index n of 0.89 was formed such that a film thickness is 19 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 9 were manufactured by the same method as in Example 1, except for the absorption layer 14.

A phase difference of the absorption layer 14 of Example 9, which was formed as described above, at a wavelength of 13.5 nm was 230 degrees.

### <Example 10>

An absorption control film (lower layer 14a) made of tin (Sn) and oxygen (O) having an extinction coefficient k of 0.070 was formed such that a film thickness is 19 nm, and a phase control film (upper layer 14b) made of ruthenium (Ru) and having a refractive index n of 0.89 was formed such that a film thickness is 28 nm on the absorption control film (lower layer 14a). When a crystallinity of the absorption layer 14 including the film made of tin (Sn) and oxygen (O) and the ruthenium (Ru) film, which were formed as described above, was measured by X-ray diffractometer (XRD), it was found to be amorphous.

The reflective photomask blank 100 and the reflective photomask 200 of Example 10 were manufactured by the same method as in Example 1, except for the absorption layer 14.

A phase difference of the absorption layer 14 of Example 10, which was formed as described above, at a wavelength of 13.5 nm was 260 degrees.

### <Example 11>

An absorption control film (lower layer 14a) made of tantalum (Ta) having an extinction coefficient k of 0.041 was formed such that a film thickness is 4 nm, and a phase control film (upper layer 14b) made of ruthenium (Ru) having a refractive index n of 0.89 was formed such that a film thickness is 39 nm on the absorption control film (lower layer 14a). When a crystallinity of the absorption layer 14 including the tantalum (Ta) film and the ruthenium (Ru) film, which were formed as described above, was measured by X-ray diffractometer (XRD), it was found to be amorphous.

The reflective photomask blank 100 and the reflective photomask 200 of Example 11 were manufactured by the same method as in Example 1, except for the absorption layer 14.

A phase difference of the absorption layer 14 of Example 11, which was formed as described above, at a wavelength of 13.5 nm was 246 degrees.

### <Example 12>

An absorption control film (lower layer 14a) made of niobium (Nb) having an extinction coefficient k of 0.005 was formed such that a film thickness is 4 nm, and a phase control film (upper layer 14b) made of ruthenium (Ru) having a refractive index n of 0.89 was formed such that a film thickness is 39 nm on the absorption control film (lower layer 14a). When a crystallinity of the absorption layer 14 including the niobium (Nb) film and the ruthenium (Ru) film, which were formed as described above, was measured by X-ray diffractometer (XRD), it was found to be amorphous.

The reflective photomask blank 100 and the reflective photomask 200 of Example 12 were manufactured by the same method as in Example 1, except for the absorption layer 14.

A phase difference of the absorption layer 14 of Example 12, which was formed as described above, at a wavelength of 13.5 nm was 251 degrees.

### <Example 13>

A phase control film (lower layer 14a) made of ruthenium (Ru) having a refractive index n of 0.89 was formed such that a film thickness is 39 nm, and an absorption control film (upper layer 14b) made of tin (Sn) and oxygen (O) having an extinction coefficient k of 0.070 was formed such that a film thickness is 4 nm on the phase control film (lower layer 14a). When a crystallinity of the absorption layer 14 including the ruthenium (Ru) film, the tin (Sn), and the oxygen (O), formed as described above, was measured by X-ray diffractometer (XRD), it was found to be amorphous.

The reflective photomask blank 100 and the reflective photomask 200 of Example 13 were manufactured by the same method as in Example 1, except for the absorption layer 14.

A phase difference of the absorption layer 14 of Example 13, which was formed as described above, at a wavelength of 13.5 nm was 248 degrees.

### <Example 14>

An absorption control film (lower layer 14a) made of indium (In) and oxygen (O) and having an extinction coefficient k of 0.067 was formed such that a film thickness is 8 nm, and a phase control film (upper layer 14b) including ruthenium (Ru) and having a refractive index n of 0.89 was formed such that a film thickness is 36 nm on the absorption control film (lower layer 14a). When a crystallinity of the absorption layer 14 including the film made of indium (In) and oxygen (O) and the ruthenium (Ru) film, which were formed as described above, was measured by X-ray diffractometer (XRD), it was found to be amorphous.

The reflective photomask blank 100 and the reflective photomask 200 of Example 14 were manufactured by the same method as in Example 1, except for the absorption layer 14.

In addition, the absorption control film made of indium (In) and oxygen (O) is denoted as "InO" for convenience in the table. That is, in the present example, the composition of the absorption control film made of indium (In) and oxygen (O) is not limited to In:O = 1:1.

A phase difference of the absorption layer 14 of Example 14, which was formed as described above, at a wavelength of 13.5 nm was 245 degrees.

### <Example 15>

An absorption control film (lower layer 14a) made of chromium (Cr) having an extinction coefficient k of 0.039 was formed such that a film thickness is 7 nm, and a phase control film (upper layer 14b) made of niobium (Nb) having a refractive index n of 0.934 was formed such that a film thickness is 62 nm on the absorption control film (lower layer 14a). When a crystallinity of the absorption layer 14 including the chromium (Cr) film and the niobium (Nb) film, which were formed as described above, was measured by X-ray diffractometer (XRD), it was found to be amorphous.

The reflective photomask blank 100 and the reflective photomask 200 of Example 15 were manufactured by the same method as in Example 1, except for the absorption layer 14.

A phase difference of the absorption layer 14 of Example 15, which was formed as described above, at a wavelength of 13.5 nm was 252 degrees.

### <Example 16>

An absorption control film (lower layer 14a) made of tantalum (Ta) having an extinction coefficient k of 0.041 was formed such that a film thickness is 14 nm, and a phase control film (upper layer 14b) made of niobium (Nb) having a refractive index n of 0.934 was formed such that a film thickness is 53 nm on the absorption control film (lower layer 14a). When a crystallinity of the absorption layer 14 including the tantalum (Ta) film and the niobium (Nb) film, which were formed as described above, was measured by X-ray diffractometer (XRD), it was found to be amorphous.

The reflective photomask blank 100 and the reflective photomask 200 of Example 16 were manufactured by the same method as in Example 1, except for the absorption layer 14.

A phase difference of the absorption layer 14 of Example 16, which was formed as described above, at a wavelength of 13.5 nm was 239 degrees.

### <Example 17>

An absorption control film (lower layer 14a) made of chromium (Cr) having an extinction coefficient k of 0.039 was formed such that a film thickness is 30 nm, and a phase control film (upper layer 14b) made of molybdenum (Mo) having a refractive index n of 0.923 was formed such that a film thickness is 29 nm on the absorption control film (lower layer 14a). When a crystallinity of the absorption layer 14 including the chromium (Cr) film and the molybdenum (Mo) film, which were formed as described above, was measured by X-ray diffractometer (XRD), it was found to be amorphous.

The reflective photomask blank 100 and the reflective photomask 200 of Example 17 were manufactured by the same method as in Example 1, except for the absorption layer 14.

A phase difference of the absorption layer 14 of Example 17, which was formed as described above, at a wavelength of 13.5 nm was 231 degrees.

### <Comparative Example 1>

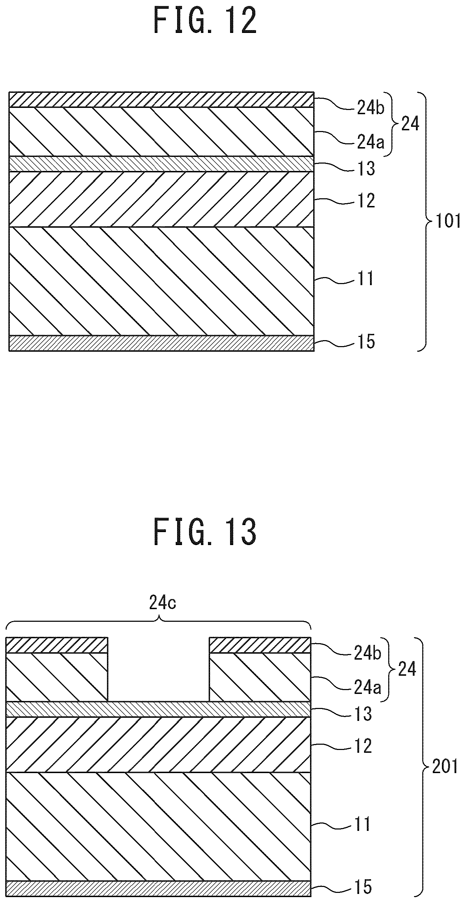

As illustrated in FIG. 12, the absorption control film (lower layer 24a) was made of tantalum nitride (TaN) having an extinction coefficient k of 0.031, such that a film thickness thereof is 58 nm. In addition, the phase control film (upper layer 24b) was made of tantalum oxide (TaO) having a refractive index n of 0.95, such that a film thickness thereof is 2 nm. When a crystallinity of the absorption layer 24 including the tantalum nitride (TaN) film and the tantalum oxide (TaO) film, which were formed as described above, was measured by X-ray diffractometer (XRD), it was found to be amorphous. Here, the present comparative example is based on a reflective photomask of an existing film in which tantalum (Ta) in the related art is used as a main component.

The reflective photomask blank 101 and the reflective photomask 201 including the absorption pattern 24c of Comparative Example 1 illustrated in FIGS. 12 and 13 were manufactured by the same method as in Example 1, except for a forming of the absorption layer 24.

The phase difference of the absorption layer 24 of Comparative Example 1, which was formed as described above, at a wavelength of 13.5 nm was 160 degrees.

### <Comparative Example 2>

An absorption control film (lower layer 24a) made of tin (Sn) and oxygen (O) having an extinction coefficient k of 0.070 was formed such that a film thickness is 11 nm, and a phase control film (upper layer 24b) made of ruthenium (Ru) and having a refractive index n of 0.89 was formed such that a film thickness is 24 nm on the absorption control film (lower layer 24a). When a crystallinity of the absorption layer 24 including the film made of tin (Sn) and oxygen (O) and the ruthenium (Ru) film, which were formed as described above, was measured by X-ray diffractometer (XRD), it was found to be amorphous.

The reflective photomask blank 101 and the reflective photomask 201 of Comparative Example 2 were manufactured by the same method as in Example 1, except for the absorption layer 24.

The phase difference of the absorption layer 24 of Comparative Example 2, which was formed as described above, at a wavelength of 13.5 nm was 180 degrees.

### <Comparative Example 3>

An absorption control film (lower layer 24a) made of tin (Sn) and oxygen (O) having an extinction coefficient k of 0.070 was formed such that a film thickness is 7 nm, and a phase control film (upper layer 24b) consisting of ruthenium (Ru) and having a refractive index n of 0.89 was formed such that a film thickness is 40 nm on the absorption control film (lower layer 24a). When a crystallinity of the absorption layer 24 including the film made of tin (Sn) and oxygen (O) and the ruthenium (Ru) film, which were formed as described above, was measured by X-ray diffractometer (XRD), it was found to be amorphous.

The reflective photomask blank 101 and the reflective photomask 201 of Comparative Example 3 were manufactured by the same method as in Example 1, except for the absorption layer 24.

The phase difference of the absorption layer 24 of Comparative Example 3, which was formed as described above, at a wavelength of 13.5 nm was 284 degrees.

### <Comparative Example 4>

An absorption control film (lower layer 24a) made of tin (Sn) and oxygen (O) having an extinction coefficient k of 0.070 was formed such that a film thickness is 15 nm, and a phase control film (upper layer 24b) made of ruthenium (Ru) and having a refractive index n of 0.89 was formed such that a film thickness is 22 nm on the absorption control film (lower layer 24a). When a crystallinity of the absorption layer 24 including the film made of tin (Sn) and oxygen (O) and the ruthenium (Ru) film, which were formed as described above, was measured by X-ray diffractometer (XRD), it was found to be amorphous.

The reflective photomask blank 101 and the reflective photomask 201 of Comparative Example 4 were manufactured by the same method as in Example 1, except for the absorption layer 24.

The phase difference of the absorption layer 24 of Comparative Example 4, which was formed as described above, at a wavelength of 13.5 nm was 188 degrees.

### <Comparative Example 5>

An absorption control film (lower layer 24a) made of tin (Sn) and oxygen (O) having an extinction coefficient k of 0.070 was formed such that a film thickness is 1 nm, and a phase control film (upper layer 24b) made of ruthenium (Ru) and having a refractive index n of 0.89 was formed such that a film thickness is 30 nm on the absorption control film (lower layer 24a). When a crystallinity of the absorption layer 24 including the film made of tin (Sn) and oxygen (O) and the ruthenium (Ru) film, which were formed as described above, was measured by X-ray diffractometer (XRD), it was found to be amorphous.

The reflective photomask blank 101 and the reflective photomask 201 of Comparative Example 5 were manufactured by the same method as in Example 1, except for the absorption layer 24.

The phase difference of the absorption layer 24 of Comparative Example 5, which was formed as described above, at a wavelength of 13.5 nm was 188 degrees.

### <Evaluation>

For the reflective photomasks obtained in Examples 1 to 17 and Comparative Examples 1 to 5 described above, the transfer performance was evaluated by the following method. The transfer performance was confirmed by a wafer exposure evaluation. In addition, the resolution was evaluated by a normalized image log-slope (NILS) value.

By using an EUV exposure apparatus (NXE3300B: manufactured by ASML), an absorption pattern of the reflective photomask manufactured in each of the examples and the comparative examples was transferred and exposed on a semiconductor wafer to which an EUV positive chemical amplification type resist was applied. At this time, an exposure amount was adjusted such that a hole pattern was transferred to 19 nm as designed.

After that, the transferred resist pattern was observed and a line width thereof was measured by an electron beam dimension measuring machine, the resolution was confirmed, and the evaluation was performed based on four levels of "⊚", "∘", "Δ", and "×" as follows.

### <Evaluation criteria>

⊚: a case where the NILS value was 2.60 or more
∘: a case where the NILS value was 2.50 or more and less than 2.60
Δ: a case where the NILS value was 2.47 or more and less than 2.50
×: a case where the NILS value was less than 2.47

Table 1 shows the above evaluation results.

For the NILS value, when the evaluation was "Δ" or higher, it was evaluated as pass, because there was no problem with the transfer performance.

**[Table 1]**

| Ex. | Absorption control film | | | | Phase control film | | | | Absorption layer | | | Evaluation |
|---|---|---|---|---|---|---|---|---|---|---|---|---|
| | Upper layer/lower layer | Material | k value | Film thickness (nm) | Upper layer/lower layer | Material | n value | Film thickness (nm) | Total film thickness | Phase difference (degree) | NILS | |
| 1 | Lower layer | SnO | 0.07 | 9 | Upper layer | Ru | 0.89 | 26 | 35 | 192 | 2.61 | ⊚ |
| 2 | Lower layer | SnO | 0.07 | 13 | Upper layer | Ru | 0.89 | 20 | 33 | 192 | 2.47 | Δ |
| 3 | Lower layer | SnO | 0.07 | 8 | Upper layer | Ru | 0.89 | 38 | 46 | 266 | 2.60 | ⊚ |
| 4 | Lower layer | SnO | 0.07 | 1.2 | Upper layer | Ru | 0.89 | 44 | 45.2 | 266 | 2.48 | Δ |
| 5 | Lower layer | SnO | 0.07 | 4 | Upper layer | Ru | 0.89 | 39 | 43 | 248 | 2.81 | ⊚ |
| 6 | Lower layer | SnO | 0.07 | 5 | Upper layer | Ru | 0.89 | 39 | 44 | 248 | 2.77 | ⊚ |
| 7 | Lower layer | SnO | 0.07 | 22 | Upper layer | Ru | 0.89 | 22 | 44 | 210 | 2.65 | ⊚ |
| 8 | Lower layer | SnO | 0.07 | 20 | Upper layer | Ru | 0.89 | 27 | 47 | 263 | 2.70 | ⊚ |
| 9 | Lower layer | SnO | 0.07 | 21 | Upper layer | Ru | 0.89 | 19 | 40 | 230 | 2.75 | ⊚ |
| 10 | Lower layer | SnO | 0.07 | 19 | Upper layer | Ru | 0.89 | 28 | 47 | 260 | 2.72 | ⊚ |
| 11 | Lower layer | Ta | 0.041 | 4 | Upper layer | Ru | 0.89 | 39 | 43 | 246 | 2.75 | ⊚ |
| 12 | Lower layer | Nb | 0.005 | 4 | Upper layer | Ru | 0.89 | 39 | 43 | 251 | 2.59 | ○ |
| 13 | Upper layer | SnO | 0.07 | 4 | Lower layer | Ru | 0.89 | 39 | 43 | 248 | 2.81 | ⊚ |
| 14 | Lower layer | InO | 0.067 | 8 | Upper layer | Ru | 0.89 | 36 | 44 | 245 | 2.82 | ⊚ |
| 15 | Lower layer | Cr | 0.039 | 7 | Upper layer | Nb | 0.934 | 62 | 69 | 252 | 2.48 | Δ |
| 16 | Lower layer | Ta | 0.041 | 14 | Upper layer | Nb | 0.934 | 53 | 67 | 239 | 2.51 | ○ |
| 17 | Lower layer | Cr | 0.039 | 30 | Upper layer | Mo | 0.923 | 29 | 59 | 231 | 2.76 | ⊚ |

| Comp. Ex. | Absorption control film | | | | Phase control film | | | | Absorption layer | | | Evaluation |
|---|---|---|---|---|---|---|---|---|---|---|---|---|
| | Upper layer/lower layer | Material | k value | Film thickness (nm) | Upper layer/lower layer | Material | n value | Film thickness (nm) | Total film thickness | Phase difference (degree) | NILS | |
| 1 | Lower layer | TaN | 0.031 | 58 | Upper layer | TaO | 0.95 | 2 | 60 | 160 | 2.37 | × |
| 2 | Lower layer | SnO | 0.07 | 11 | Upper layer | Ru | 0.89 | 24 | 35 | 180 | 2.46 | × |
| 3 | Lower layer | SnO | 0.07 | 7 | Upper layer | Ru | 0.89 | 40 | 47 | 284 | 2.34 | × |
| 4 | Lower layer | SnO | 0.07 | 15 | Upper layer | Ru | 0.89 | 22 | 37 | 188 | 2.44 | × |
| 5 | Lower layer | SnO | 0.07 | 1 | Upper layer | Ru | 0.89 | 30 | 31 | 188 | 1.34 | × |

Table 1 shows the evaluation results of Examples 1 to 17 and Comparative Examples 1 to 5.

In Comparative Example 1 including the tantalum (Ta)-based absorption layer of the related art having a film thickness of 60 nm, the phase difference was 160 degrees and the NILS was 2.37. It was found that, in a case where the phase difference of the absorption pattern layers is 190 degrees or more and 270 degrees or less as in Examples 1 to 17, the NILS was great and the resolution was improved, compared to Comparative Example 1.

Hereinafter, a result of comparing NILS of the Examples and the Comparative Examples will be described in detail with reference to Table 1 and the graph illustrated in FIGS. 3 and 5.

Comparing Examples 1, 3, and 5, when the phase difference is 192 degrees, 266 degrees, and 248 degrees, respectively, the NILS is 2.61, 2.60, and 2.81, respectively, and all of the NILS are evaluated as "⊚". In Comparative Examples 2 and 3, when the phase difference was 180 degrees and 284 degrees, respectively, the NILS is 2.46 and 2.34, respectively, and both are evaluated as "×".

From these, it was found that the phase difference had sufficient resolution in a case of being 190 degrees or more and 270 degrees or less. That is, a suitable range of the phase difference of the absorption layer in the reflective photomask is different from "around 180 degrees" which has been used in the design concept in the related art, and can be said to be "in a range of 190 degrees or more and 270 degrees or less".

Comparing Examples 1, 3, and 5, when the phase difference is 192 degrees, 266 degrees, and 248 degrees, respectively, the NILS is 2.61, 2.60, and 2.81, respectively, and all of the NILS are evaluated as "⊚".

Comparing Example 7, Example 8, Example 9, and Example 10, the phase differences are 210 degrees, 263 degrees, 230 degrees, and 260 degrees, respectively. Here, the NILS is 2.65, 2.70, 2.75, and 2.72 in the case of Examples 7, 8, 9, and 10, respectively, and all of them are evaluated as "⊚".

In addition, as illustrated in FIG. 3, compared with a case where the phase difference is 180 degrees, the NILS is improved by 1% or more when the phase difference is in a range of 190 degrees or more and 270 degrees or less, by 7% or more when the phase difference is in a range of 210 degrees or more and 265 degrees or less, or by 11% or more when the phase difference is in a range of 230 degrees or more and 260 degrees or less.

From the above, in order to improve the resolution, the phase difference of the absorption layer is preferably in a range of 190 degrees or more and 270 degrees or less, more preferably in a range of 210 degrees or more and 265 degrees or less, and most preferably in a range of 230 degrees or more and 260 degrees or less.

Comparing Example 5, Example 11, and Example 12, the film thickness of the absorption control film is the same as the film thickness of the Ru film which is a phase control film. The materials used for the absorption control films of Example 5, Example 11, and Example 12 are SnO (extinction coefficient k is 0.070), Ta (extinction coefficient k is 0.041), and Nb (extinction coefficient k is 0.005), respectively. Here, NILS is 2.81, 2.75, and 2.59 in the cases of Example 5, Example 11, and Example 12, respectively.

Comparing Example 5 and Example 13, the film thickness of the SnO, which is the absorption control film, and the film thickness of the Ru film, which is the phase control film, are the same, but the positions of the layers are interchanged. Here, the phase difference and the NILS are all equal to each other, and are 248 degrees and 2.81, respectively.

From this, in a case where the absorption layer has a two-layer structure, it is found that the phase difference and the NILS are all equal even in a case where the upper layer and the lower layer are interchanged.

Comparing Example 5 and Example 14, the materials used for the absorption control films of Example 5 and Example 14 are SnO (extinction coefficient k is 0.070) and InO (extinction coefficient k is 0.067), respectively, and all the materials have an extinction coefficient of 0.041 or more. Here, NILS is 2.81 and 2.82 in the case of Examples 5 and 14, respectively.

As described above, in a case where a material having a large extinction coefficient k, such as tin oxide (Sn) or indium oxide (In), is used in the absorption control film, the resolution is found to be good.

Comparing Comparative Example 4 and Comparative Example 5, the phase difference is the same as 188 degrees. Here, the NILS is 2.44 and 1.34 in the case of Comparative Example 4 and Comparative Example 5, respectively. In this case, all of the NILSs are evaluated as "×".

The reflective photomask blank and the reflective photomask of the present disclosure are not limited to the embodiments and the examples described above, and various modifications can be made within a range not impairing the features of the invention.

### Industrial Applicability

The reflective photomask blank and the reflective photomask according to the present invention can be suitably used to form a nanofabrication pattern by the EUV exposure in the manufacturing step such as a semiconductor integrated circuit or the like.

### Reference Signs List

- 1: substrate
- 2: reflective layer
- 3: protective layer
- 4: absorption layer
- 4a: absorption layer (lower layer)
- 4b: absorption layer (upper layer)
- 4c: absorption pattern
- 5: oxide film
- 5a: oxide film pattern
- 10: reflective photomask blank
- 20: reflective photomask
- 11: substrate
- 12: reflective layer
- 13: protective layer
- 14: absorption layer
- 14a: absorption layer (lower layer)
- 14b: absorption layer (upper layer)
- 14c: absorption pattern
- 15: back surface conductive film
- 16: resist film
- 16a: resist pattern
- 100: reflective photomask blank
- 200: reflective photomask
- 24: absorption layer
- 24a: absorption layer (lower layer)
- 24b: absorption layer (upper layer)
- 24c: absorption pattern
- 101: reflective photomask blank
- 201: reflective photomask

## Claims

1. A reflective photomask blank comprising:
a substrate;
a reflective layer having a multi-layer film structure, formed on the substrate, and configured to reflect an EUV light;
a protective layer formed on the reflective layer and configured to protect the reflective layer; and
an absorption layer formed on the protective layer and configured to absorb the EUV light,
wherein the absorption layer has a multi-layer structure of two or more layers having different functions, and
the absorption layer has a phase difference in a range of 190 degrees or more and 270 degrees or less.

2. The reflective photomask blank according to claim 1, wherein the absorption layer includes at least an absorption control film.

3. The reflective photomask blank according to claim 2, wherein the absorption layer includes the absorption control film and a phase control film.

4. The reflective photomask blank according to claim 2 or 3, wherein the absorption control film contains a material having an extinction coefficient k of 0.041 or more, and
a film thickness of the absorption layer is 60 nm or less.

5. The reflective photomask blank according to any one of claims 2 to 4, wherein the absorption control film is configured with a material containing at least one or more elements of tin (Sn), indium (In), tantalum (Ta), silver (Ag), tellurium (Te), nickel (Ni), cobalt (Co), copper (Cu), platinum (Pt), palladium (Pd), iridium (Ir), gold (Au), or zinc (Zn).

6. The reflective photomask blank according to any one of claims 2 to 5, wherein the absorption layer includes the absorption control film and a phase control film, and
the phase control film has a refractive index n with respect to the EUV light less than 0.93.

7. The reflective photomask blank according to any one of claims 2 to 5, wherein the absorption layer includes the absorption control film and a phase control film, and
the phase control film has a refractive index n with respect to the EUV light less than 0.92.

8. The reflective photomask blank according to any one of claims 2 to 7, wherein the absorption layer includes the absorption control film and a phase control film, and
the phase control film is configured with a material containing at least one or more elements of ruthenium (Ru), rhodium (Rh), molybdenum (Mo), palladium (Pd), silver (Ag), platinum (Pt), gold (Au), osmium (Os), iridium (Ir), or rhenium (Re).

9. The reflective photomask blank according to any one of claims 1 to 8, wherein the absorption layer has a phase difference in a range of 210 degrees or more and 265 degrees or less.

10. The reflective photomask blank according to any one of claims 1 to 8, wherein the absorption layer has a phase difference in a range of 230 degrees or more and 260 degrees or less.

11. A reflective photomask comprising:
a substrate;
a reflective layer having a multi-layer film structure, formed on the substrate, and configured to reflect an EUV light;
a protective layer formed on the reflective layer and configured to protect the reflective layer; and
an absorption pattern layer formed on the protective layer and configured to absorb the EUV light,
wherein the absorption pattern layer has a multi-layer structure of two or more layers having different functions, and
the absorption pattern layer has a phase difference in a range of 190 degrees or more and 270 degrees or less.

12. The reflective photomask according to claim 11, wherein the absorption pattern layer includes at least a patterned absorption control film.

13. The reflective photomask according to claim 12, wherein the absorption pattern layer includes the absorption control film and a patterned phase control film.

14. The reflective photomask according to claim 12 or 13, wherein the absorption control film contains a material having an extinction coefficient k of 0.041 or more, and
a film thickness of the absorption pattern layer is 60 nm or less.

15. The reflective photomask according to any one of claims 12 to 14, wherein the absorption control film is configured with a material containing at least one or more elements of tin (Sn), indium (In), tantalum (Ta), silver (Ag), tellurium (Te), nickel (Ni), cobalt (Co), copper (Cu), platinum (Pt), palladium (Pd), iridium (Ir), gold (Au), or zinc (Zn).

16. The reflective photomask according to any one of claims 12 to 15, wherein the absorption pattern layer includes the absorption control film and a patterned phase control film, and
the phase control film has a refractive index n with respect to the EUV light less than 0.93.

17. The reflective photomask according to any one of claims 12 to 15, wherein the absorption pattern layer includes the absorption control film and a patterned phase control film, and
the phase control film has a refractive index n with respect to the EUV light less than 0.92.

18. The reflective photomask according to any one of claims 12 to 17, wherein the absorption pattern layer includes the absorption control film and a patterned phase control film, and
the phase control film is configured with a material containing at least one or more elements of ruthenium (Ru), rhodium (Rh), molybdenum (Mo), palladium (Pd), silver (Ag), platinum (Pt), gold (Au), osmium (Os), iridium (Ir), or rhenium (Re).

19. The reflective photomask according to any one of claims 11 to 18, wherein the absorption pattern layer has a phase difference in a range of 210 degrees or more and 265 degrees or less.

20. The reflective photomask according to any one of claims 11 to 18, wherein the absorption pattern layer has a phase difference in a range of 230 degrees or more and 260 degrees or less.
